# EUROPEAN PATENT APPLICATION

(11) **EP 2 527 499 A1**
(43) Date of publication of application: **28.11.2012**
(21) Application number: 11734781.5
(22) Date of filing: 21.01.2011
(51) Int. Cl.: C25D 7/06, B32B 15/01, B32B 15/08, C25D 5/10, H05K 1/09

(54) **ROUGHENED COPPER FOIL, METHOD FOR PRODUCING SAME, AND COPPER CLAD LAMINATE AND PRINTED CIRCUIT BOARD**

(30) Priority: 22.01.2010 JP 2010012086
(71) Applicant: Furukawa Electric Co., Ltd., Chiyoda-ku Tokyo 100-8322 (JP)
(72) Inventor: UNO, Takeo, Tokyo 100-8322 (JP); FUJISAWA, Satoshi, Tokyo 100-8322 (JP)
(74) Representative: Thun, Clemens
(86) International application number: PCT/JP2011/051132
(87) International publication number: WO 2011/090175

(57) **Abstract**

Provided is a roughened copper foil which has excellent properties in forming a fine patterned-circuit and good transmission properties in a high-frequency range and show high adhesiveness to a resin base and good chemical resistance. A surface-roughened copper foil, which is obtained by roughening at least one face of a base copper foil (untreated copper foil) so as to increase the surface roughness (Rz) thereof, relative to the surface roughness (Rz) of said base copper foil, by 0.05-0.3 µm and has a roughened surface with a surface roughness (Rz) after roughening of 1.1 µm or less, wherein said roughened surface comprises roughed grains in a sharp-pointed convex shape which have a width of 0.3-0.8 µm, a height of 0.4-1.8 µm and an aspect ratio [height/width] of 1.2-3.5.

## Description

### Technical Field

The present invention relates to a copper foil and a method for producing the same.
The present invention particularly relates to roughened copper foil used in a multi-layer printed circuit board, flexible printed circuit board, or the like and a method for producing the same.
More specifically, the present invention relates to roughened copper foil which has excellent properties in formation of fine patterned circuits and transmission properties in the high frequency band and is excellent in adhesion with a resin substrate and a method for producing the same.

### Background Art

In recent years, electronics have been made increasingly smaller in size and thickness. In particular, the various types of electronic parts which are used in mobile devices such as mobile phones use IC(Integrated circuit)s, LSI, and so on which are highly integrated and have small-sized, high density printed circuits built in them. To deal with this, higher density is also required in the circuit wiring patterns in high density mounting-use multi-layer printed circuit boards and flexible printed circuit boards etc. used for the same (hereinafter, sometimes simply referred to as "printed circuit boards"). So-called fine pattern printed circuit boards having circuit wiring patterns with fine widths and intervals of circuit wirings are being demanded. For example, flexible printed circuit boards having patterns with widths and intervals of circuit wirings of approximately 50 µm are being demanded. Further, in printed circuit boards used in small-sized ICs, printed circuit boards with micro circuit wirings of widths and intervals of circuit wirings of approximately 30 µm are being demanded.

Printed circuit boards are produced as follows.
First, the surface of an electrically insulating substrate made of an epoxy resin, polyimide, or the like (sometimes referred to as a "resin substrate") is covered with a thin copper foil for forming circuits, then this is heated and pressed to produce a copper clad laminated board.
Then, the copper clad laminated board is formed with through holes and the through holes are plated, then the copper foil on the surface of the copper clad laminated board is formed with mask patterns and etched so as to form wiring patterns provided with desired widths and intervals of circuit wirings, then finally is formed with a solder resist and other finishing.

In the process of production of the above printed circuit board, the step of forming wiring patterns by the subtractive method on a copper clad laminated board (hereinafter sometimes simply referred to as a "laminated board") comprised of a resin substrate on both surfaces of which copper foil is disposed will be exemplified.

First, one copper foil surface (front surface side) of the laminated board has a photosensitive film (resist) bonded to it. An exposure apparatus provided with an exposure mask to a surface of the photosensitive film is used to transfer (project) the patterns of the exposure mask onto the photosensitive film by irradiation of exposure light. Parts of the photosensitive film which are not exposed are removed by a development step to form film resist patterns (etching resist).
Then, the parts of the copper foil which are not covered by the film resist patterns (are exposed) are removed by an etching step to form the wirings on the front surface side. As a chemical used in the etching step, use is made of, for example, one obtained by adding hydrochloric acid to an aqueous solution of ferric chloride or cupric chloride. After that, the film resist patterns which have been already used in the etching step are removed from the circuit wirings by using, for example, an alkali aqueous solution.
In the same step as that described above, predetermined printed wirings are formed to the copper foil of the other surface (back surface side).
Note that, in order to facilitate soldering with electronic parts or the printed circuit board, electroless Sn plating is applied to end portions of the circuit wirings according to need. As the chemical used in the electroless Sn plating step, use is made of one obtained by adding hydrochloric acid to an aqueous solution of Sn ions.

After forming circuit wirings on the front and back surfaces of the resin substrate according to the steps explained above, blind via holes are formed for connecting the front surface side circuit wirings and back surface side circuit wirings of the resin substrate.
For formation of the blind via holes, holes are formed in the resin substrate exposed at the front surface side by a CO₂ laser. In the formation of holes by this laser, smear of the resin substrate (insulating resin) remains at the bottom parts of the holes (roughened surfaces of the back surface side circuit wirings). In order to remove this smear, desmearing is carried out to remove smear using oxidizing chemicals such as a potassium permanganate solution etc.

Next, in order to impart conductivity to the insulating parts of the side surfaces of the holes formed in the resin substrate, a copper layer (conductive layer) is formed by electroless copper plating. As the pretreatment for this, soft etching is applied to treat the bottom parts of the holes (back surface side circuit wirings) by a sulfuric acid-hydrogen peroxide soft etchant to remove metal plating or antirust plating of the copper foil.

Finally, electrolytic copper plating is applied to the top of the conductive layer formed by the electroless copper plating to connect the side surfaces and bottom parts of the holes (back surface side circuit wirings) and the front surface side circuit wirings and thereby complete a double-sided printed circuit board.
Note that, it is also possible to perform the step of forming wirings on the copper foil on the back surface side after forming the blind via holes.

### Citations List

### Patent Literature (PLT)

PLT 1: Japanese Patent Publication No. 05-029740 PLT 2: Japanese Patent Publication No. 2004-005588
PLT 3: Japanese Patent Publication No. 2005-344174
PLT 4: Japanese Patent Publication No. 2006-175634

### Summary of Invention

### Technical Problem

Conventionally, in copper foil used for a printed circuit board, the surface on the side to be hot pressed to the resin substrate is processed to form a roughened surface having projections. This roughened surface is made to exhibit an anchoring effect for the resin substrate. The adhesion strength between the resin substrate and the copper foil is raised to secure reliability of the printed circuit board (see, for example, Patent Literature (PLT) 1).

However, when using a conventional roughened copper foil as the copper foil for a printed circuit board having high density micro wirings, projecting parts formed by the roughening which was applied in order to secure adhesive strength with the resin substrate deeply dig into the resin substrate. In order to completely etch away the dug-in projecting parts, long etching is needed.
Unless the dug-in projecting parts are completely removed, a state is exhibited where those parts remain connected to the circuit wirings as they are (residual copper) at the end parts of the circuit wirings (boundary parts between the copper foil and the resin substrate), therefore insulation failure between circuit wirings and variations in conduction due to a drop in straightness of the end parts of the circuit wirings will be caused. There was the possibility that the reliability of the formation of a fine pattern circuit was influenced.

Further, high speed transmission of electric signals is required for electronic parts in order to raise the information processing speed of electronics and handle high frequency wireless communications. Application of high frequency-matching boards is advancing as well. In high frequency compatible boards, it is necessary to reduce transmission loss for high speed transmission of electric signals. Therefore, in addition to lowering the dielectric constant of the resin substrate, reduction of transmission loss of the circuit wirings using copper foil as the conductor is demanded.
In the high frequency band exceeding several GHz, due to the skin effect, current flowing in the circuit wirings is concentrated at the copper foil surface. The penetration depth δ due to the skin effect is defined by δ=(2/(2πf·µ·σ))^{1/2}, where f indicates the frequency, µ indicates the magnetic permeability of the conductor, and σ indicates the conductance of the conductor.
When copper foil having numerous relief shapes resulting from conventional roughening was used as copper foil for high frequency compatible boards, there was the inconvenience that the current concentrated at only the surface regions having large resistance due to relief shapes and the transmission loss became large, so the transmission properties were degraded.

Furthermore, when using copper foil subjected to the conventional roughening in the step of forming blind via holes, the resin substrate (insulating resin) is easily remains in the blind via holes and removal of the insulating resin (smear) remaining in the bottom parts of the blind via holes becomes insufficient, therefore, formation of the conductive layers by electroless copper plating becomes insufficient. This sometimes becomes a cause of poor connection of the upper and lower circuits at the blind via holes.

In order to eliminate these disadvantages, for copper foil used in fine pattern compatible and high frequency compatible printed circuit boards and so on, a method of bonding smooth copper foil to a resin substrate without roughening and using the result has been studied (see, for example, PLTs 2, 3, and 4).
However, although smooth copper foils are excellent in the properties of formation of fine pattern circuits and the transmission properties in the high frequency band, it is difficult to sufficiently raise the adhesion between the copper foils and the resin substrate. Further, in the etching step of the circuit wirings or the Sn plating step for the end parts of the circuit wirings in which smooth copper foil is used, chemicals sometimes permeate the interface between the copper foil and the resin substrate. Further, when using copper foil having a smooth surface, the adhesion falls due to the heat load in the process of production of a printed circuit board or during use of the product. In particular, since fine pattern compatible printed circuit boards are constituted so that the bonded area between the circuit wirings (copper foil) and the resin substrate is extremely small, then, if permeation of chemicals or drop of adhesion after heat load occurs, there may be peeled off of the circuit wirings from the resin substrate. Accordingly, copper foil having a good adhesion with a resin substrate is desired.

### Solution to Problem

As explained above, copper foil satisfying adhesion with a resin substrate, heat resistance, chemical resistance, properties in circuit formation, signal transmission properties in the high frequency band, and soft etching properties has been desired.
Accordingly, an object of the present invention is to provide a roughened copper foil which is excellent in formation of fine pattern circuits and transmission properties in the high frequency band and is excellent in adhesion with a resin substrate.
Further, the present invention provides a copper clad laminated board obtained by bonding roughened copper foil to a resin substrate and a printed circuit board using the above copper-clad laminated board.

The inventors engaged in intensive studies and consequently found that by making the amount and shape of the roughening to be applied to the surface of copper foil within suitable ranges, it is possible to achieve roughening excellent in formability of fine pattern circuits and signal transmission properties in the high frequency band and excellent in adhesion with a resin substrate.

The roughened copper foil of the present invention is copper foil having a roughened surface which is obtained by roughening at least one surface of a base copper foil (untreated copper foil) so as to increase its Rz by 0.05 to 0.3 µm relative to the surface roughness Rz of the base copper foil and has a surface roughness Rz after the roughening not more than 1.1 µm, wherein the roughened surface is formed by roughening grains of sharp tip projecting shapes having a width of 0.3 to 0.8 µm, a height of 0.4 to 1.8 µm, and an aspect ratio [height/width] of 1.2 to 3.5.

The method for producing the roughened copper foil of the present invention includes the steps of roughening a non-surface-treated base copper foil so that its Rz increases by 0.05 to 0.3 µm relative to the surface roughness Rz of the base copper foil to provide a roughened surface which has a surface roughness Rz after roughening of 1.1 µm or less and thus forming a roughened surface comprised of roughening grains of sharp tip projecting shapes having a width of 0.3 to 0.8 µm, a height of 0.4 to 1.8 µm, and an aspect ratio [height/width] of 1.2 to 3.5.

The present invention provides a copper clad laminated board formed by laminating the above roughened copper foil on a resin substrate.
Further, the present invention provides a printed circuit board using the above copper clad laminated board. Advantageous Effects of Invention

The roughened copper foil of the present invention is a roughened copper foil which is excellent in formability of fine pattern circuits and transmission properties in the high frequency band and is excellent in adhesion with a resin substrate and chemical resistance (prevents permeation of chemicals in the interface between the copper foil and the resin substrate).
Further, according to the copper clad laminated board using the roughened copper foil of the present invention, there can be provided a printed circuit board which is not only suitable for fine patterns and substrates applicable for high frequency, but also has good adhesion between the resin substrate and the copper foil and has high reliability.

### Brief Description of Drawings

[FIG. 1] A view illustrating a process of an embodiment of the present invention.
[FIG. 2] A view showing an enlarged cross-section of a roughened copper foil according to an embodiment of the present invention.
[FIG. 3] A view showing a cross-section of a copper clad laminate board of the embodiment of the present invention. Description of Embodiments

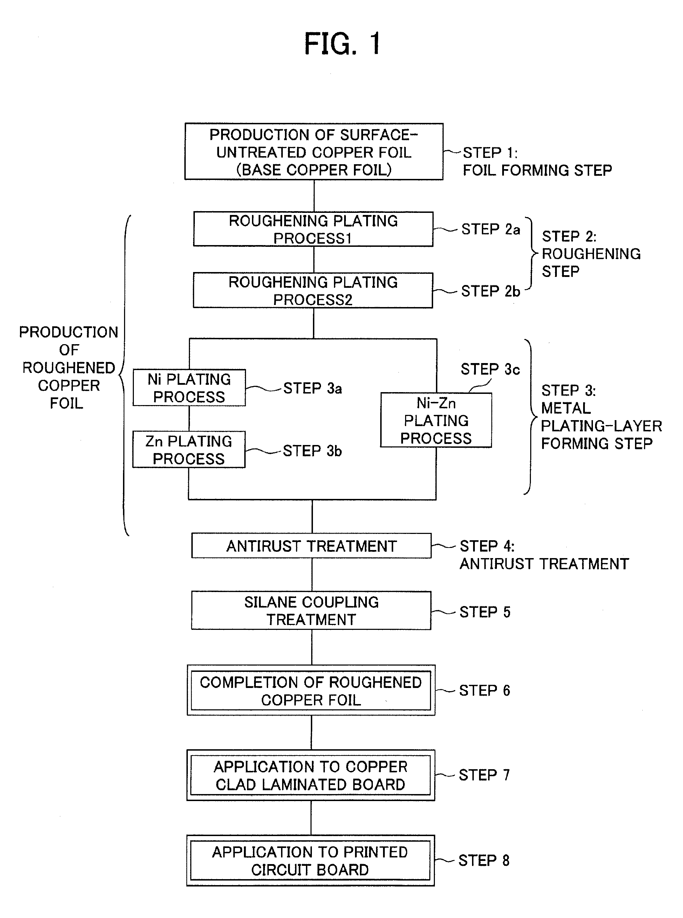

As shown in the steps in FIG. 1, after producing a non-surface-treated copper foil (base copper foil) (step 1), the surface of that copper foil is roughened for improving the adhesion with the resin substrate (steps 2 and 3) and, according to need, is surface treated for keeping roughening grains from dropping off and for rustproofing (step 4).
In an embodiment of the present invention, as the surface treatment, roughening mainly comprised of copper or copper alloy is applied (step 2), surface treatment by Ni, Zn, and an alloy of the same or Cr is applied to its top (steps 3 and 4), and, further, according to need, silane coupling treatment (step 5) for improving the adhesion with the resin substrate is applied.

In the roughening for improving adhesion between the copper foil and resin substrate, the rougher the roughening grains, that is, the rougher the relief shapes of the surface, the better the adhesion. However, the formability of fine pattern circuits and signal transmission properties in the high frequency band and the desmear-ability at the time of formation of blind via holes tend to become worse.

In the embodiment of the present invention, the surface of the base copper foil (untreated copper foil) is first roughened to increase the surface roughness Rz of the base copper foil by 0.05 to 0.30 µm by copper or copper alloy (step 2). At this time, the surface roughness Rz after the roughening is made 1.1 µm or less.
Note that, the roughening applied by copper or copper alloy described above is preferably carried out in a range whereby the surface roughness Ra is increased by 0.02 to 0.05 µm, to thereby control the Ra after the roughening to 0.35 µm or less.
When the treatment is carried out so that the amount of increase of the surface roughness Rz after the roughening is less than the lower limit value of 0.05 µm, the adhesion with the resin substrate becomes a bit low. If the amount of increase of Rz exceeds the upper limit value of 0.30 µm, the surface becomes rougher, so the circuit formability and signal transmission properties which will be explained later fall.
Further, by preventing the surface roughness Rz after the roughening from exceeding 1.1 µm, a roughened copper foil which is excellent in formability of fine pattern circuits and signal transmission properties in the high frequency band can be formed without impairing the adhesion with the resin substrate.
Note that, the surface roughnesses Ra and Rz are values measured according to the provisions of Japanese Industrial Standard: JIS-B-0601.

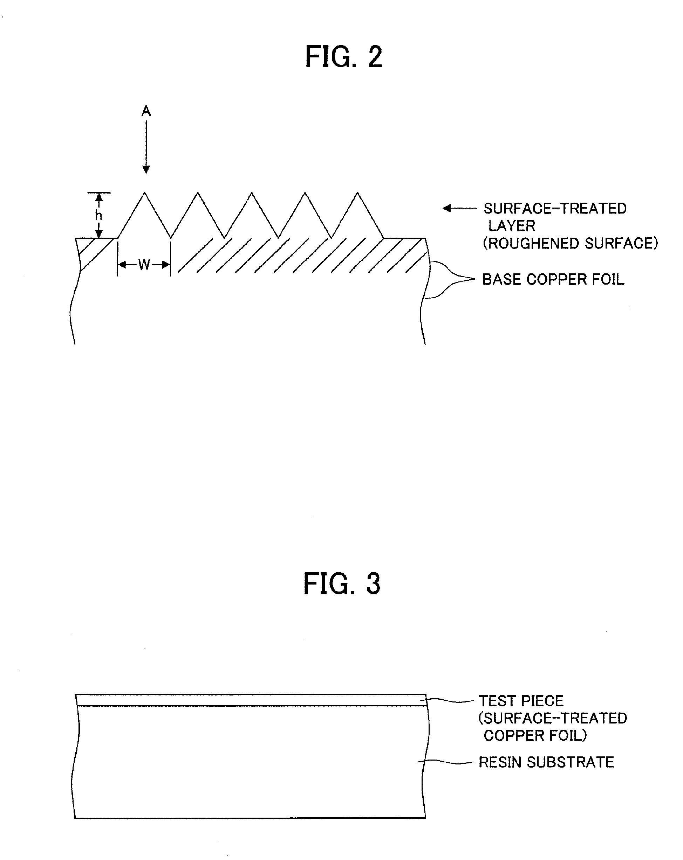

In the embodiment of the present invention, the roughened surface of the copper foil is given, as schematically shown as an enlarged cross-section in FIG. 2, sharp tip projecting shapes for forming roughness of a size of a width w of 0.3 to 0.8 µm and a height h of 0.4 to 1.8 µm. By giving such shapes, when adhering this to an insulating resin, the roughened relief shapes easily dig into the resin substrate (anchor effect), so a good adhesion can be obtained. Note that, in a projecting shape, the width w is the length of the root portion on the foil surface, and the height h is the height from the foil surface to the peak (top).
Further, in the embodiment of the present invention, the aspect ratio [height/width] of the shape of a projecting part at the roughened surface is made 1.2 to 3.5. The reason for making the aspect ratio [height/width] 1.2 to 3.5 is that the adhesion with the insulating resin is not sufficient if the ratio is less than 1.2, while the possibility of the roughened projecting parts dropping off from the copper foil becomes higher if the aspect ratio is larger than 3.5, so this are not preferred.

Further, in the embodiment of the present invention, in FIG. 2, preferably roughening is applied so that a three-dimensional surface area of the projections as determined by a laser microscope becomes 3 times or more relative to a two-dimensional surface area when viewing the projections from A. The reason for applying the roughening so that the three-dimensional surface area obtained by the laser microscope becomes 3 times or more of the two-dimensional surface area is that the adhesion falls due to reduction of the contact area with the resin substrate if the former surface area is less than 3 times, therefore chemicals used in the treatment cannot be prevented from permeating into the interface between the copper foil and the resin substrate (chemical resistance is degraded) in the etching in the circuit wiring forming step (FIG. 1, step 8), the plating process in the electroless Sn plating step for the end portions of the circuit wirings (FIG. 1, step 3), soft etching in the step of forming blind via holes, and so on. Further, this is because the area of contact of the soft etchant with the roughening grains and the surface of the base copper foil is small, so the etching speed in the soft etching becomes slow.

In the embodiment of the present invention, suitable control of the shape of the roughening grains and their surface roughness and surface area leads to an increase of the surface area and increase of the adhesion by the anchor effect and therefore an improvement in heat-resistant adhesion. Further, after forming the blind via holes by the laser processing, the effects are realized of reducing resin residue at the roughened portions at the time of the desmearing of the bottom parts of the via holes and giving good soft etching properties by the increase of the surface area.

In the embodiment of the present invention, the amount of roughening when applying roughening to the base copper foil (the weight of roughening grains deposited in the roughening) is preferably 3.56 to 8.91 g (equivalent thickness: 0.4 to 1.0 µm) per 1m². The reason for the control of the roughening amount to 3.56 to 8.91 g per 1m² is that the range becomes optimal for deposition of roughening grains onto the base copper foil (untreated copper foil) so that the surface roughness Rz increases by 0.05 to 0.30 µm or the surface roughness Ra increases by 0.02 to 0.05 µm. Here, as the base copper foil, preferably use is made of one having the surface roughness Ra of 0.30 µm or less and the surface roughness Rz of 0.8 µm or less.

In the embodiment of the present invention, the roughened surface to be provided on the surface of the base copper foil is formed by: Cu; or an alloy of Cu and Mo; or a copper alloy containing at least one type of element selected from a group consisting of Ni, Co, Fe, Cr, V, and W, in Cu, or the alloy of Cu and Mo. A roughened surface (projections) having a desired shape is obtained by Cu particles or alloy particles of Cu and Mo.
Preferably, by forming roughening grains by 2 or more types of elements containing at least one type of element selected from a group consisting of Ni, Co, Fe, Cr, V, and W, Cu, in addition to or Cu and Mo, there is obtained preferable projections having more uniformity.

The at least one type of element selected from a group consisting of Mo, Ni, Co, Fe, Cr, V, and W contained in the roughening grains preferably accounts for 0.01 ppm to 20% relative to the amount of presence of Cu. This is because a desired effect cannot be expected if the amount of presence is less than 0.01 ppm, while dissolution becomes difficult when etching a circuit pattern with an alloy composition where the amount exceeds 20%. Further, in order to obtain uniform projections, desirably the compositions of the various treatment solutions, current density, solution temperature, and treatment time are optimized.

Further, the surfaces of the roughening grains may be provided with a metal-plating layer of at least one type of metal selected from a group consisting of Ni, Ni alloy, Zn, and Zn alloy for the purpose of improving the adhesion with the resin substrate, heat resistance, chemical resistance, powder dropping off property, and so on (FIG. 1, step 2).
In order to achieve these objects, desirably the amount of deposition metal of Ni, Ni alloy, Zn, or Zn alloy is 0.05 mg/dm² to 10 mg/dm².
On the above metal-plating layer, desirably an antirust layer made of Cr plating (chromate plating) or chromate coating is formed.

Further, preferably, a silane coupling treatment is applied on the antirust layer (FIG. 1, step 5).

In the embodiment of the present invention, when applying Ni-Zn alloy plating as the metal-plating layer, desirably the Zn content (wt%) shown in the following equation 1 is 6% to 30%, and Zn is deposited in an amount of 0.08 mg/dm² or more.

Zn content (wt%) = Zn deposition amount/(Ni deposition amount + Zn deposition amount) × 100... (1)

The amount of deposition of Zn is prescribed for improvement of the heat resistance and chemical resistance of the copper foil and resin substrate. The heat resistance is not improved if the Zn content (wt%) in the Ni-Zn alloy is less than 6%, while the chemical resistance becomes poor if the content is larger than 30%. Neither is preferred.
Further, Zn is desirably deposited to 0.08 mg/dm² or more. The reason for deposition of Zn to 0.08 mg/dm² or more is improvement of the heat resistance and that the effect of heat resistance cannot be expected if the amount is less than 0.08 mg/dm²_{.}
Further, Ni is preferably deposited to 0.45 to 3 mg/dm². The amount of deposition of Ni is prescribed because of the improvement of heat resistance and influence upon the soft etching properties and because the improvement of the heat resistance cannot be expected so much if the amount of deposition of Ni is less than 0.45 mg/dm², while there is apprehension of an adverse influence being exerted upon the soft etching properties if it is larger than 3 mg/dm².

On the antirust layer, according to a need, there may be treated by silane coupling treatment in order to improve the adhesion between the roughened copper foil and the resin substrate (FIG. 1, step 4).
A silane coupling agent can be suitably selected from among epoxy-based, amino-based, methacryl-based, vinyl-based, mercapto-based, and other agents according to the resin substrate concerned.
For a resin substrate used in a high frequency compatible substrate, preferably an epoxy-based, amino-based, or vinyl-based coupling agent having particularly excellent affinity is selected. For the polyimide used in a flexible printed circuit board, preferably an amino-based coupling agent having particularly excellent affinity is selected.

### Production of copper clad laminated board (FIG. 1, step 7)

As the resin substrate, a polymer resin containing various ingredients can be used.
For a rigid circuit board or IC-use printed circuit board, a phenol resin or epoxy resin is mainly used. Polyimide or polyamide-imide is mainly used for a flexible substrate.
For a fine pattern (high density) circuit board or high frequency substrate, there is used a heat resistant resin having a high glass transition point (Tg) as a material having a good dimensional stability, a material with a little warp and twist, a material with little thermal contraction, and other materials.
As the heat-resistant resin, there can be mentioned, for example, heat-resistant epoxy resin, BT (bismaleimide triazine) resin, polyimide, polyamide imide, polyether imide, polyether ether ketone, polyphenylene ether, polyphenylene oxide, cyanate ester resin, and so on.

As a method of bonding such a resin substrate with roughened copper foil in order to produce a copper clad laminated board, there may be applied a hot pressing method, continuous rolling laminate method, continuous belt pressing method, and so on. Hot press bonding can be carried out without use of a binder or the like.
Further, as another method, there is also the method of coating the surface of the roughened copper foil with a resin in a molten state or in a state dissolved in a solvent, then curing the resin by heat treatment.

Recently, resin-coated copper foil comprised of copper foil with a roughened surface covered by an adhesive resin such as an epoxy resin or polyimide in advance and where the adhesive resin is made a semi-cured state (B stage) has been used as copper foil for circuit formation. The resin side for adhesion use has been hot press bonded to the resin substrate to produce a multi-layer printed circuit board or flexible printed circuit board. In this method, the adhesion between the copper foil and the resin substrate can be raised even by micro roughening. Therefore, by combining this with the present invention, a copper clad laminated board having a good adhesion can be produced, so the result is more effective.

When the transmission speed of the electric signals becomes fast, the quality of the resin substrate ends up having an important effect on the characteristic impedance, signal transmission speed, etc., therefore a base material excellent in dielectric constant, dielectric loss, and other characteristics is demanded as a resin substrate suitable for a high frequency circuit use printed circuit board. Various materials are proposed in order to satisfy this. For example, for the high speed transmission of electric signals, as the resin substrate having a small dielectric constant and small dielectric loss, there can be mentioned liquid crystal polymer, polyethylene fluoride, an isocyanate compound, polyetherimide, polyetheretherketone, polyphenylene ether, etc.

The copper clad laminated board using the roughened copper foil of the embodiment of the present invention is excellent in adhesion between the copper foil and the resin substrate and can be formed with blind via holes by a CO₂ gas laser or other laser. Therefore, in the step of forming the blind via holes, even after etching, boring, desmearing, soft etching, copper plating, and other processing are carried out, it is possible to use this without the problem of peeling off between the copper foil and the resin substrate.
A blind via hole is a via in which only one side of a printed circuit board is opened and is described in Publication "Printed Circuit Terminology" etc. edited by the Japan Electronics Packing and Circuits Association.

As explained above, according to the copper clad laminated board of the embodiment of the present invention, the steps of forming blind via holes by a CO₂ laser or other laser, boring, desmearing, soft etching, copper plating, and other processing can be easily carried out. Accordingly, for irradiation energy of the laser and other processing conditions, suitably optimized conditions can be selected according to the thickness of the resin substrate and the type of the resin. Also the optimized conditions can be selected for the method of forming holes in a copper clad laminated board, a desmearing method for the inside and bottom of holes and a soft etching method which pre-treats the electroless copper plating for the side surfaces and bottom portions of the holes after desmearing, so it becomes possible to form optimal holes at desired positions.

### EXAMPLES

A further detailed explanation will be given of examples based on the embodiment of the present invention, but the present invention is not limited to them.

The surface treatment steps of the copper foil of the embodiment of the present invention will be explained in order from the foil forming step with reference to the process diagram of FIG. 1.

### (1) Foil forming step (step 1)

A base copper foil (untreated copper foil) was produced by the following plating bath and plating conditions.

### (Plating bath and plating conditions)

Copper sulfate: 50 to 80 g/liter as copper concentration
Concentration of sulfuric acid: 30 to 70 g/liter
Concentration of chlorine: 0.01 to 30 ppm
Solution temperature: 35 to 45°C
Current density: 20 to 50A/dm²

### (2) Roughening step (step 2)

The roughening of the surface of the base copper foil was carried out in an order of a roughening plating process 1, then roughening plating process 2 which have different conditions.

### (Roughening plating process 1: Step 2a)

Copper sulfate: 5 to 10 g/liter as copper concentration
Concentration of sulfuric acid: 30 to 120 g/liter
Ammonium molybdate: 0.1 to 5.0 g/liter as Mo metal
Solution temperature: 20 to 60°C
Current density: 10 to 60A/dm²

### (Roughening plating process 2: Step 2b)

Copper sulfate: 20 to 70 g/liter as copper concentration
Concentration of sulfuric acid: 30 to 120 g/liter
Solution temperature: 20 to 65°C
Current density: 5 to 65A/dm²

### (3) Metal-plating layer forming step (step 3)

A metal-plating layer was applied by the following plating bath and plating conditions. Note that, when applying an Ni plating, a Zn plating was applied to the top of that. A Zn plating was not applied when an Ni-Zn plating was applied.

### (Ni plating: Step 3a)

Nickel sulfate hexahydrate: 240 g/liter
Nickel chloride hexahydrate: 45 g/liter
Boric acid: 30 g/liter
Sodium hypophosphite: 5 g/liter
Solution temperature: 50°C
Current density: 0.5 A/dm²

### (Zn plating: Step 3b)

Zinc sulfate heptahydrate: 24 g/liter
Sodium hydroxide: 85 g/liter
Solution temperature: 25°C
Current density: 0.4A/dm²

### (Ni-Zn alloy plating: Step 3c)

Nickel sulfate: 0.1 g/liter to 200 g/liter, preferably 20 g/liter to 60 g/liter as nickel concentration,
Zinc sulfate: 0.01 g/liter to 100 g/liter, preferably 0.05 g/liter to 50 g/liter as zinc concentration
Ammonium sulfate: 0.1 g/liter to 100 g/liter, preferably 0.5 g/liter to 40 g/liter
Solution temperature: 20 to 60°C
pH: 2 to 7
Current density: 0.3 to 10A/dm²

### (4) Antirust treatment (step 4)

After the metal-plating layer treatment, a Cr plating was applied by the following plating bath and plating conditions.

### (Cr plating)

Chromic anhydride: 0.1 g/liter to 100 g/liter
Solution temperature: 20 to 50°C
Current density: 0.1 to 20A/dm²

### (5) Silane treatment (step 5)

After the antirust plating process, a silane coupling treatment was applied by the following treatment solution and treatment conditions.
Silane species: γ-aminopropyltrimethoxysilane
Silane concentration: 0.1 g/liter to 10 g/liter
Solution temperature: 20 to 50°C

### Preparation of test specimens

Surface roughened copper foils obtained by applying the surface treatments according to steps 2 to 5 to the untreated copper foil formed under the electroplating conditions according to step 1 described above were provided as test pieces and processed to sizes and forms suitable for various evaluations shown in Table 1 to prepare test specimens. The characteristic values of the test specimens are shown in Table 1.

### Evaluation of characteristics of test specimens

### (1) Measurement of amounts of deposition of metal

A fluorescent X-ray spectrometers (ZSX Primus, made by Rigaku Corporation, analysis diameter: 35ϕ) was used for analysis.

### (2) Measurement of surface roughness

A surface roughness measuring device (SE1700 made by Kosaka Laboratory Ltd.) was used for measurement.

### (3) Calculation of aspect ratio

A cross-section of the roughening grains obtained by FIB was measured for width and height by a scanning type electron microscope (SEM). The numerical value of "height÷width" was determined as the aspect ratio.

Note that, as shown in FIG. 2, the width is the length of the root portion of the foil surface, and the height is the measured value of the length from the root portion to the peak of the foil surface.

### (4) Calculation of the surface area

A laser microscope (VK8500 made by Keyence Corporation) was used to measure the three-dimensional surface area. The area of the field of measurement seen from the upper portion A in FIG. 2 was defined as the two-dimensional surface area. The numerical value of "surface area ratio = three-dimensional surface area÷two-dimensional surface area" was defined as the surface area ratio.

### (5) Initial adhesion (measurement of initial adhesion strength)

As shown in FIG. 3, the test specimens were bonded to the resin substrate materials, then were measured for adhesion strengths. As the resin substrate, use was made of a commercially available polyimide resin (UPILEX-25VT made by Ube Industries Ltd.)
The adhesion strength was found by using a Tensilon tester (made by Toyo Seiki Seisakusho Ltd.), etching each test specimen after adhesion to a resin substrate to circuit wirings having a width of 1 mm, then fastening the resin side to a stainless steel sheet by a double sided tape and peeling off the circuit wirings in a direction at 90 degrees at a rate of 50 mm/min. An initial adhesion of 0.8 kN/m or more was judged as passing. The judgment criteria are shown in Table 1.

### (6) Heat resistance (measurement of adhesion strength after heat treatment)

Test specimens after adhesion with resin substrates were measured for adhesion strengths after heat treatment at 150°C for 168 hours.

A heat resistance of a 90% or more initial peel strength was judged as passing. The judgment criteria are shown in Table 1.

### (7) Chemical resistance (measurement of adhesion strength after acid treatment)

The test specimens after adhesion to resin substrates were measured for adhesion strengths after dipping them in a hydrochloric acid solution of water:hydrochloric acid = 1:1 ratio at ordinary temperature for 1 hour.

A chemical resistance of 0.8 kN/m or more was judged as passing. The judgment criteria are shown in Table 1.

### (8) Circuit formability (measurement of remaining copper at end parts of circuit wirings)

Each test specimen after adhesion with the resin substrate was etched to circuit wirings of a width of 1 mm. The width of remaining copper at the end parts of the wiring circuits (interface between the copper foil and the resin substrate) was measured.

A circuit formability of less than 3.0 µm was judged as passing. The judgment criteria are shown in Table 1.

### (9) Transmission properties (measurement of transmission loss in high frequency band)

The surface-treated test specimens were bonded with the resin substrates, then samples for measuring the signal transmission properties were prepared and measured for transmission loss in the high frequency band. As the resin substrate, use was made of the commercially available polyphenylene ether resin (MEGTRON 6 made by Panasonic Electric Works Co., Ltd.)

For measurement and evaluation of the transmission, a known stripline resonator method suitable for measurement in a 1 to 25 GHz range (method of measuring an S21 parameter with a micro strip structure: dielectric thickness of 50 µm, conductor length of 1.0 mm, conductor thickness of 12 µm, conductor circuit width of 120 µm, and characteristic impedance of 50Ω in a state without a cover ray film) was used to measure the signal transmission loss (dB/100 mm) at a frequency of 5 GHz.

As the signal transmission properties, a transmission loss less than 25 dB/100 mm was judged as passing. The judgment criteria are shown in Table 1.

### (10) Soft etching properties (measurement of etching amount of roughened surface)

Each test specimen was masked at the surface which was not roughened, then was measured for weight. After that, it was dipped in a soft etchant (CPE-920 made by Mitsubishi Gas Chemical Co., Inc.) at 25°C for 120 seconds, then the test specimen was measured for weight again. The etched weight was calculated from the change of weight before and after the soft etching and was converted to the thickness dissolved away by the etching.

A soft etching property of a case of 1.0 µm or more etching was judged as passing. The judgment criteria are shown in Table 1.

### [Example 1: Only roughening]

The surface of a base copper foil (untreated copper foil) was roughened to give the increased amount of roughening shown in Table 1 and, as shown in FIG. 2, give a roughened surface comprised of sharp-tip projecting particles. The aspect ratio and surface area ratio at this time are shown in Table 1. Note, no metal plating layer, antirust plating layer, and silane treated layer were formed.

The results of evaluation of the initial adhesion, heat resistance, chemical resistance, properties in circuit formation, transmission properties, and soft etching properties by using this roughened copper foil are shown in Table 1.

### [Examples 2 to 6 and 11]

The surfaces of base copper foils (untreated copper foils) were roughened to give the increased amounts of roughening shown in Table 1 and were formed with metal plating layers, antirust plating layers, and silane treated layers to thereby obtain roughened surfaces comprised of sharp tip projecting particles as shown in FIG. 2. The aspect ratios and surface area ratios at this time are shown in Table 1. On each of these surfaces, a metal-plating layer of Ni, a metal-plating layer of Zn, and an antirust plating layer of Cr having deposition amounts shown in Table 1 were sequentially formed. Finally, a silane treated layer was formed.

The results of evaluation of the initial adhesion, heat resistance, chemical resistance, properties in circuit formation, transmission properties, and soft etching properties by using these roughened copper foils are shown in Table 1.

### [Examples 7 to 10]

The surfaces of base copper foils (untreated copper foils) were roughened to give the increased amounts of roughening shown in Table 1. The aspect ratios and surface area ratios at this time are shown in Table 1. On each of these surfaces, a metal-plating layer made of Ni-Zn and an antirust plating layer of Cr having deposition amounts shown in Table 1 were sequentially formed. Finally, a silane treated layer was formed.

The results of the same evaluation as that, for Example 1 using these roughened copper foils are shown in Table 1.

### [Comparative Example 1]

The surface of a base copper foil (untreated copper foil) was successively formed with an antirust plating layer of Cr and a silane treated layer without providing roughening and a metal-plating layer.

The results of the same evaluation as that, for Example 1 using this roughened copper foil are shown in Table 1.

### [Comparative Example 2]

The surface of a base copper foil (untreated copper foil) was not roughened, but was successively formed with a metal-plating layer of Ni, a metal-plating layer of Zn, and an antirust plating layer of Cr having deposition amounts shown in Table 1. Finally, a silane treated layer was formed

The results of the same evaluation as that, for Example 1 using this roughened copper foil are shown in Table 1.

### [Comparative Examples 3 to 5]

The surfaces of base copper foils (untreated copper foils) were roughened to give increased amounts of roughening as shown in Table 1. The aspect ratios and surface area ratios at this time are shown in Table 1. On each of these surfaces, a metal-plating layer of Ni, a metal-plating layer of Zn, and an antirust plating layer of Cr having deposition amounts shown in Table 1 were sequentially formed. Finally, a silane treated layer was formed.

The results of the same evaluation as that, for Example 1 using these roughened copper foils are shown in Table 1.

### [Comparative Example 6]

The surface of a base copper foil (untreated copper foil) was not roughened, but was successively formed with a metal-plating layer made of Ni-Zn and an antirust plating layer of Cr having deposition amounts shown in Table 1. Finally, a silane treated layer was formed.

The results of the same evaluation as that, for Example 1 using this roughened copper foil are shown in Table 1.

[Table 1]

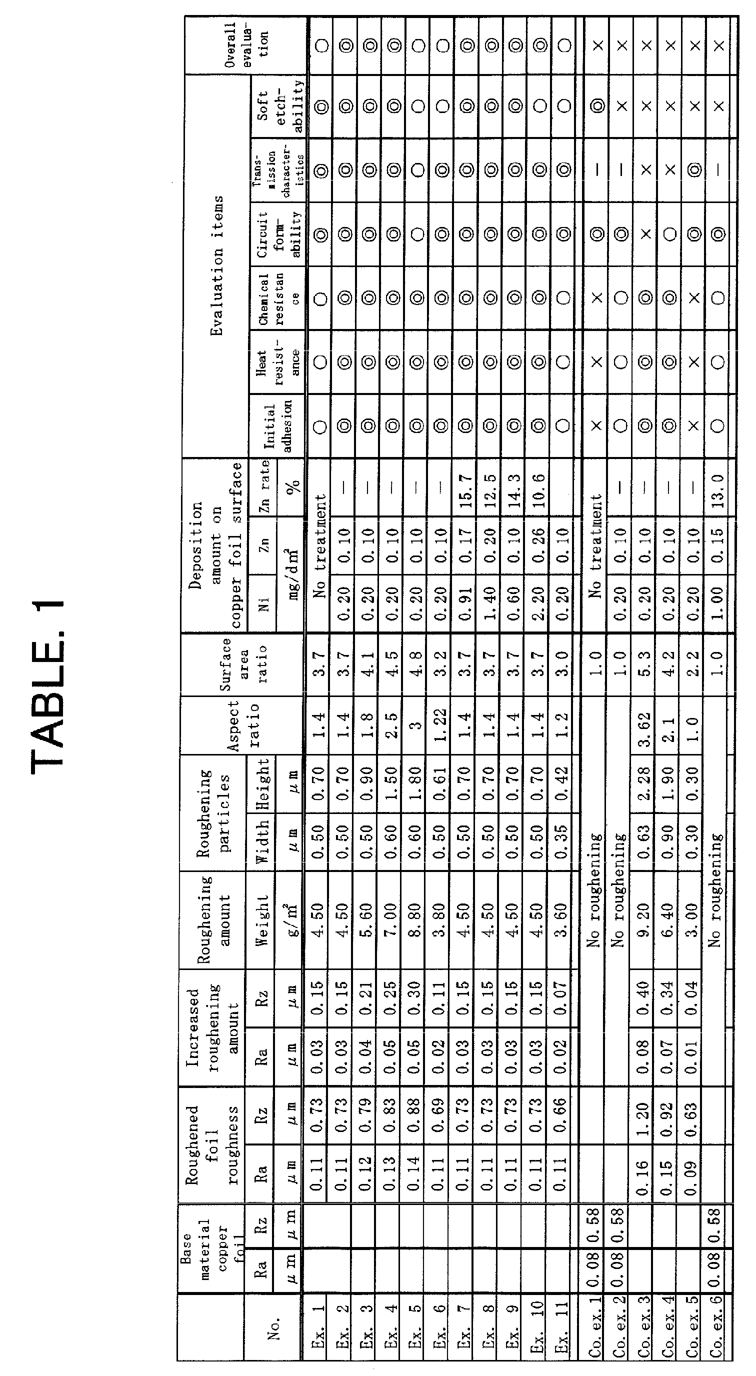

In evaluations, the judgment criteria shown in Table 1 are as follows. Double circle: VG (very good), o: good, G (good) or fair, and × :P (poor): substandard.

The judgment criteria in the evaluation items were as follows.

### Initial adhesion (kN/m)

VG: 1.0 or more, G: 0.8 or more, but less than 1.0, and P: less than 0.8
Heat resistance [survival rate of adhesion after heat resistance test (%)]
VG: 90 or more, G: 72 or more, but less than 90, P: less than 72
Chemical resistance [adhesion after chemical resistance test (kN/m)]
VG: 1.0 or more, G: 0.8 or more, but less than 1.0, P: less than 0.8
Circuit formability (measurement of residual copper at end parts of circuit wirings (µm)]
VG: less than 1.0, G: 1.0 or more, but less than 3.0, P: 3.0 or more
Transmission properties (transmission loss at a frequency of 5 GHz (dB/100 mm)]
VG: less than 15, G: 15 or more, but less than 25, P: 25 or more
Soft etching properties [amount of dissolution in a soft etchant (µm)]
VG: 1.4 or more, G: 1.0 or more, but less than 1.4, P: less than 1.0

As shown in Table 1, in Example 1, the roughness of the roughened foil, increased amount of roughening, aspect ratio, and surface area ratio were within the ranges, and the circuit formability, signal transmission properties, and soft etching properties were excellent. However, no metal plating layer, antirust plating layer, and silane treated layer were applied. Therefore, when compared with Examples 2 to 4 etc., the initial adhesion, heat resistance, and chemical resistance are slightly low (Overall evaluation: G)

In Example 2 to Example 4, metal-plating layers, antirust plating layers, and silane treated layers were applied, therefore the roughness of roughened foils, increased amounts of roughening, aspect ratios, and surface area ratios were within the ranges, and the evaluation items were within good ranges. (Overall evaluation: VG)

In Example 5, a metal-plating layer, antirust plating layer, and silane treated layer were formed, and the increased amount of roughening and aspect ratio were within the ranges. However, their values are biggish, so, circuit formability, transmission properties, and soft etching properties are slightly low. (Overall evaluation: G)

In Example 6, a metal-plating layer, antirust plating layer, and silane treated layer were formed, and the aspect ratio and surface area ratio were within the criteria. However, their values are smallish, so, the soft etching property is slightly low. (Overall evaluation: G)

In Example 7 to Example 9, metal-plating layers, antirust plating layers, and silane treated layers were formed. Since the roughness of roughened foils, increased amounts of roughening, aspect ratios, and surface area ratios were within the ranges and the alloy compositions were applied in proper ranges, as a result, the evaluation items were within good ranges (Overall evaluation: VG)

In Example 10, a metal-plating layer, antirust plating layer, and silane treated layer were formed, but the deposition amount of Ni was a bit large, therefore the soft etching property is slightly low. (Overall evaluation: G)

In Example 11, the increased amount of roughening, roughening width, and roughening height are within the criteria. However, the values are small, therefore the initial adhesion, heat resistance, chemical resistance, and soft etching property are slightly low.

In Comparative Example 1, the roughening and metal plating were not carried out, therefore the soft etching property was good, but the initial adhesion, heat resistance, and chemical resistance were sub standard. (Overall evaluation: P)

In Comparative Example 2, the surface treatment was carried out, but the roughening was not carried out, therefore the soft etching property was sub standard.

### (Overall evaluation: P)

In Comparative Example 3, the roughness of roughened foil, increased amount of roughening, roughening height, and aspect ratio were out of the criteria, therefore the properties in circuit formation, transmission properties, and soft etching property were sub standard. (Overall evaluation: P)

In Comparative Example 4, the increased amount of roughening, roughening width, and roughening height were out of the criteria, therefore the soft etching property was sub standard. (Overall evaluation: P)

In Comparative Example 5, the increased amount of roughening was small, and the roughening width, roughening height, and aspect ratio were small as well, therefore the initial adhesion, heat resistance, chemical resistance, and soft etching property were substandard. (Overall evaluation: P)

In Comparative Example 6, the roughening was not carried out, therefore the soft etching property was substandard. (Overall evaluation: P)

As explained above, the roughened copper foil of the embodiment of the present invention is a roughened copper foil which satisfies the initial adhesion with the resin substrate, heat resistance, chemical resistance, properties in circuit formation, signal transmission properties, and soft etching properties and is industrially excellent. Further, according to the roughening method of the copper foil of the embodiment of the present invention, a roughened copper foil which is excellent in adhesion with the resin substrate and industrially satisfies the chemical resistance and soft etching properties can be produced.
Further, the copper clad laminated board and printed circuit board of the embodiment of the present invention have excellent effects that the adhesion strength between the resin substrate and the copper foil is strong, a chemical resistance exists in the circuit formation, and the soft etching properties are satisfied.

## Claims

1. A copper foil having a roughened surface which is obtained by roughening at least one surface of a base copper foil (untreated copper foil) so as to increase its Rz by 0.05 to 0.3 µm relative to the surface roughness Rz of the base copper foil, and has a surface roughness Rz after the roughening not more than 1.1 µm, wherein
the roughened surface is formed by roughening grains of sharp tip projecting shapes having a width of 0.3 to 0.8 µm, a height of 0.4 to 1.8 µm, and an aspect ratio [height/width] of 1.2 to 3.5.

2. A roughened copper foil as set forth in claim 1, wherein a ratio of a three-dimensional surface area to a two-dimensional surface area of the roughened surface is 3 or more.

3. A roughened copper foil as set forth in claim 1 or 2, wherein the roughened surface is given a metal plating layer of any of Ni, an Ni alloy, Zn, and a Zn alloy.

4. A roughened copper foil as set forth in claim 3, wherein the surface of the metal plating layer is given an antirust treatment of any of a Cr plating, Cr alloy plating, and chromate plating.

5. A roughened copper foil as set forth in claim 4, wherein the surface subjected to the antirust treatment is given a silane coupling treatment.

6. A method for producing a roughened copper foil comprising the steps of:
roughening a non-surface-treated base copper foil by Cu or Cu alloy so that its Rz increases by 0.05 to 0.3 µm relative to the surface roughness Rz of the base copper foil, and
forming a roughened surface, where the roughened surface has a surface roughness Rz after roughening of 1.1 µm or less, and comprised of roughening grains of sharp tip projecting shapes having a width of 0.3 to 0.8 µm, a height of 0.4 to 1.8 µm, and an aspect ratio [height/width] of 1.2 to 3.5.

7. A method for producing a roughened copper foil as set forth in claim 6, wherein an amount of roughening (weight of deposition by roughening) is 3.56 to 8.91 g (equivalent thickness: 0.4 to 1.0 µm) per m².

8. A method of production as set forth in claim 6 or 7, wherein the copper alloy contains an alloy of Cu and Mo, or an alloy of Cu and at least one type of element selected from a group consisting of Ni, Co, Fe, Cr, V, and W.

9. A method of production as set forth in any one of claims 6 to 8, further comprising forming at least one type of metal-plating layer selected from a group consisting of Ni, Ni alloy, Z, and Zn alloy on the roughened surface.

10. A method of production as set forth in claim 9, further comprising carrying out an antirust treatment by any of Cr plating, Cr alloy plating, and chromate treatment on the metal-plating layer.

11. A method of production as set forth in claim 10, further comprising forming a silane coupling layer on the metal-plating layer.

12. A copper clad laminated board formed by adhering the roughened copper foil set forth in any of claims 1 to 5 or the roughened copper foil produced by the method of production set forth in any of claims 6 to 11 to one surface or both surfaces of the resin substrate.

13. A printed circuit board using the copper clad laminated board as set forth in claim 12.
